# EUROPÄISCHE PATENTSCHRIFT

(11) **EP 1 974 464 B1**
(45) Veröffentlichungstag und Bekanntmachung des Hinweises auf die Patenterteilung: **03.03.2010**
(21) Anmeldenummer: 07702719.1
(22) Anmeldetag: 12.01.2007
(51) Int. Cl.: H03B 11/02, H01T 9/00

(54) **HOCHLEISTUNGS-MIKROWELLENGENERATOR ZUM ABSTRAHLEN KURZER IMPULSE, DESSEN VERWENDUNG IN EINEM ARRAY UND ARRAY AUS DERARTIGEN MIKROWELLEN-GENERATOREN**
HIGH-POWER MICROWAVE GENERATOR FOR EMITTING SHORT PULSES, ITS USE IN AN ARRAY AND ARRAY COMPRISING SUCH MICROWAVE GENERATORS
GÉNÉRATEUR D'HYPERFRÉQUENCE DE GRANDE PUISSANCE DESTINÉ À RAYONNER DES IMPULSIONS DE COURTE DURÉE, SON UTILISATION AU SEIN D UN RÉSEAU ET RÉSEAU DE GÉNÉRATEURS D'HYPERFRÉQUENCE DE CE TYPE

(30) Priorität: 19.01.2006 DE 102006002652
(43) Veröffentlichungstag der Anmeldung: 01.10.2008
(73) Patentinhaber: Diehl BGT Defence GmbH & Co.KG, 88662 Überlingen (DE)
(72) Erfinder: URBAN, Jürgen, 91056 Erlangen (DE); STARK, Robert, 91438 Bad Windsheim (DE)
(74) Vertreter: Diehl Patentabteilung
(86) Internationale Anmeldenummer: PCT/EP2007/000246
(87) Internationale Veröffentlichungsnummer: WO 2007/082687

(56) Entgegenhaltungen:
- EP-A1- 1 473 866
- HONG K ET AL INSTITUTE OF ELECTRICAL AND ELECTRONICS ENGINEERS: "DEVELOPMENT OF ANTENNA-SOURCE SYSTEM FOR GENERATION OF HIGH-POWER ELECTROMAGNETIC PULSES" PPPS-2001. PULSED POWER PLASMA SCIENCE 2001.DIGEST OF TECHNICAL PAPERS. ( THE 28TH. IEEE INT. CONF. ON PLASMA SCIENCE: ICOPS/THE 13TH.IEEE INT. PULSED POWER CONFERENCE: PPC). LAS VEGAS, NV, JUNE 17 - 22, 2001, IEEE PULSED POWER PLASMA SCIENCE CONFERE, Bd. VOL. 1 OF 2, 17. Juni 2001 (2001-06-17), Seiten 203-206, XP001113855 ISBN: 0-7803-7120-8

## Beschreibung

Die Erfindung betrifft einen Mikrowellen-Generator gemäß dem Oberbegriff des Anspruches 1 und dessen Verwendung gemäß Anspruch 10 sowie ein Array aus solchen Mikrowellen-Generatoren.

Ein derartiger, auch als DS-HPM (damped sinusoidal high power microwavegenerator) bezeichneter Generator ist aus der DE 1 03 13 286 B3 bekannt. Zum Aufladen dessen Resonators mit Hochspannung bedient man sich vorzugsweise des so genannten Marx'schen Stoßspannungsgenerators (nachstehend einfach als Marx-Generator bezeichnet), bei dem eine Anzahl von Kondensatoren parallel auf eine hohe Spannung aufgeladen und dann mittels Funkenstrecken in Serie geschaltet wird, um einen Entladestrom mit entsprechendem Vielfachen der Ladespannung zu liefern. Damit wird die Kapazität des dem Marx-Generator nachgeschalteten Resonators aufgeladen. Der ist mit einer Funkenstrecke zum Kurzschließen seiner Kapazität bei Überschreiten der konstruktiv bedingten Gleichspannungsfestigkeit seiner Funkenstrecke ausgestattet, und mit einer Antenne mit Dipolcharakteristik zum Abstrahlen des vom stark oszillierenden impulsförmigen Entladestrom dann hervorgerufenen elektromagnetischen Feldes.

Gemäß der DE 1 03 13 286 B3 sind mehrere der so ausgelegten Resonatoren in einer Gruppe (Array) angeordnet und an einen gemeinsamen Marx-Generator zum parallelen Aufladen mit dem hochgespannten Gleichstrom angeschlossen. Ihre Funkenstrecken sind auf eine möglichst übereinstimmende Durchschlagspannung ausgelegt, so dass die Entladeströme der Resonatorkapazitäten möglichst alle gleichzeitig einsetzen. Die daraus resultierende zeitliche Überlagerung der entladestrombedingten Wechselfelder im Fernfeld bestimmt die räumliche Geometrie einer im Interesse der Fernwirkung wünschenswerten starken Richtungsbündelung der resultierenden Gruppen-Abstrahlcharakteristik.

Die Abstrahlungen der einzelnen, derart ungetriggert parallel betriebenen, Resonatoren setzen aber, abgesehen von der jeweiligen Ladezeitkonstante und dem Ansprechverhalten ihrer Funken-Schaltstrecke, insbesondere auch nach Maßgabe der Längen der Speiseleitungen vom Marx-Generator her tatsächlich unvermeidlich etwas zeitlich gegeneinander versetzt ein. Das wirkt sich entsprechend abträglich auf die gewünschte Bündelung, also Wirkreichweite der Abstrahlcharakteristik aus; und das führt in der Praxis zu einem kaum vorhersehbaren und schon deshalb auch steuerungstechnisch kaum beeinflussbaren Verschwenken der Abstrahlrichtung aus der Normalenrichtung auf das Array heraus. Für operationell einsetzbare Mikrowellengeneratoren mit derart aus einer gemeinsamen Gleichstromquelle gespeisten Gruppenanordnungen von Resonatoren, deren einzelnen Funkenstrecken im Interesse ausreichender Fernwirkung ihrer interferierenden Abstrahlungen alle in einer Zeitspanne in der typischen Größenordnung von höchstens 100 Picosekunden ansprechen sollten, ist die Anzahl der zu gruppierenden Resonatoren wegen der unterschiedlichen Längen ihrer Ladeleitungen deshalb sehr begrenzt.

In Erkenntnis dieser Gegebenheiten liegt der Erfindung die technische Problemstellung zugrunde, einen Mikrowellen-Generator anzugeben, der beim Gruppenbetrieb eine höhere Leistungsdichte erzielen lässt und möglichst auch noch ohne großen Zusatzaufwand eine gesteuerte Strahlschwenkung über einen weiten Schwenkbereich eröffnet.

Diese Aufgabe ist erfindungsgemäß gelöst durch den Einsatz von als Basismodulen mit den wesentlichen im Hauptanspruch angegebenen Merkmalen ausgestatteten Resonatoren für die Array-Gruppierung von Mikrowellen-Generatoren. Weil jedes derartiger Basismodule mit seinem eigenen, und nun triggerbaren, Marx-Generator zum Generieren der Hochspannung für das Durchschalten der Kurzschluss-Funkenstrecke seines Resonators ausgestattet ist, sind nicht nur die den Gruppenbetrieb störenden Effekte unterschiedlich langer Ladewege, sondern auch die bisher auftretenden gegenseitigen Funktionsabhängigkeiten infolge Rückwirkungen über einen gemeinsamen Ladepfad vermieden. Deshalb lassen sich nun Arrays aus sehr viel mehr Elementen (Resonatoren) gruppieren, was größer abstrahlende Bauformen insgesamt ermöglicht, also infolge Überlagerung von entsprechend mehr Einzelabstrahlungen aus einer größeren Fläche heraus eine stärkere Bündelung und somit eine größere Intensität der im Fernfeld resultierenden Abstrahlcharakteristik erbringt. Da andererseits jeder Resonator eigenständig und so mit noch ungebündelter Dipolabstrahlung wirkt, wird außerdem durch die Gruppierung von erfindungsgemäß ausgestatteten Basismodulen ein breitestmöglicher Winkelbereich für das räumliche Verschwenken der aus der Überlagerung resultierenden Abstrahlcharakteristik mittels geringfügig zeitversetzter Triggerung der einzelnen Basismodule eröffnet.

Zur praktischen Realisierung der Basismodule für die Array-Anordnung der Mikrowellen-Generatoren ist gemäß einer zu bevorzugenden Weiterbildung vorliegender Erfindung eine Integration des über eine seiner Funkernstrecken triggerbaren Marx-Generators, vorzugsweise gleich samt seiner individuell extern anregbaren Zündschaltung, in den Resonator selbst hinein vorgesehen, bei konzentrischem und dadurch besonders kompaktem Aufbau mit nicht mehr axialer sondern radialer, also ringförmiger Funkenstrecke. Zweckmäßigerweise ist dann die Gleichspannungsquelle mit dem ihr gegebenenfalls nachfolgenden Gleichspannungswandler zum Speisen des Marx-Generators in den konzentrischen Aufbau einbezogen und koaxial in einer trichterförmigen Antenne angeordnet, die sich an einen Lambda-Viertel-Resonator des Mikrowellen-Generators axial anschließt. Dadurch sind externe Verkabelungen für die interne Funktion des jeweiligen Basismoduls und somit Störeinflüsse vermieden, die ansonsten etwa infolge von Hochspannungsüberschlägen oder Hochfrequenzeinstreuungen zu Fehlfunktionen wie vorzeitiger Auslösung eines Basismoduls und demzufolge zu einer Schwächung der resultierenden Abstrahlcharakteristik führen können.

Aus dem gleichen Grunde erfolgt zweckmäßigerweise die (zur Strahloptimierung) gleichzeitige oder (zur Strahlschwenkung) geringfügig zeitversetzte Ansteuerung der Zündschaltungen in den einzelnen Basismodulen nicht elektrisch über Kabel, sondern vorzugsweise optoelektronisch. Dafür kann ein Photosensor etwa stirnseitig zugänglich in den jeweiligen Resonator integriert sein, so dass alle Basismodule eines erforderlichenfalls entsprechend lichtdicht eingehäusten Array durch Generieren eines einzigen Lichtblitzes gleichzeitig getriggert werden.

Jedenfalls liefert erfindungsgemäß ein Array aus Mikrowellen-Generatoren für HPM-Impulsabstrahlungen, zu gesteigerter Fernwirkung durch bessere Bündelung der resultierenden Abstrahlcharakteristik; exakter zeitgleich einsetzende Entladeströme ihrer Resonatoren bzw., zum Verschwenken der resultierenden Abstrahlcharakteristik, einen präziser ansteuerbaren Zeitversatz der Entladeströme, wenn dafür Basismodule eingesetzt werden, die jeder mit einem eigenen extern und vorzugsweise optisch triggerbaren Marx-Generator ausgestattet sind. Eine besonders kompakte Ausführung mit gegen Umwelteinflüsse geschützter Leitungsführung ergibt sich für jeden dieser Basismodule bei einem koaxialen Aufbau, in dem der jeweilige Marx-Generator samt seiner Zündschaltung unmittelbar im Innern des Resonators angeordnet ist, mit eingangsseitigem Anschluss des Marx-Generators axial dagegen versetzt an eine im Innern der trichterförmigen Antenne untergebrachten Gleichspannungs-Versorgung und mit seinem ausgangsseitigen Anschluss an die zentrale Elektrode einer ringförmigen Kurzschluss-Funkenstrecke des Resonators.

Zusätzliche Alternativen und Weiterbildungen zur erfindungsgemäßen Lösung ergeben sich aus den weiteren Ansprüchen und aus dem bevorzugten Realisierungsbeispiel gemäß nachstehender, auch weitere Vorteile der Erfindung behandelnder Beschreibung. Die bezieht sich auf die anliegende, im Interesse der Funktionsbeschreibung nicht ganz maßstabsgerechte Prinzipskizze eines erfindungsgemäßen Basismoduls im axialen Längsschnitt.

Das insbesondere zum Einsatz in einem Strahler-Array gemäß etwa DE 1 03 13 286 B3 (aber nun ohne Aufladung der Resonatoren aus einem gemeinsamen Marx-Generator) konzipierte Basismodul 10 vorliegender Erfindung beinhaltet den koaxialen Lambda-Viertel-Resonator 11 eines Hochleistungs-Mikrowellengenerators 12 mit daran koaxial anschließender trichterförmiger Antenne 13 in einem beiden gemeinsamen röhrenförmigen Gehäuse 14 aus hochspannungsfestem Isoliermaterial.

Der Resonator 11 des impulsförmig arbeitenden Mikrowellengenerators 12 weist eine zylindrische Kapazität 15 in Form einer von einer gestreckt topfförmigen Außenelektrode 16 distanziert konzentrisch umgebenen Innenelektrode 17 auf, welche etwa flaschenförmig ausgelegt ist und mit ihrem trichterförmigen Hals 18 an die kleine Grundfläche 19 des Hohlkegelstumpfes der Antenne 13 anschließt. Koaxial zwischen Außen- und Innenelektrode 16-17 ist eine hier radiale, also kreisringförmige Kurzchluss-Funkenstrecke 20 über die beiden Elektroden 16-17 ausgebildet, nämlich in Form eines als zentrale Funkenstrecken-Elektrode dienenden Wellenstumpfes 21, der im Innern der Außenelektrode 16 konzentrisch von deren Boden 22 vorsteht und unter allseitigem lichtem Abstand in ein Loch 23 im Boden 24 der Innenelektrode 17 hinein ragt. Der wirksame Resonator 11 ist bestimmt durch die Kapazität 15 und die Induktivität der Funkenstrecke 20, abgesehen von den wirksamen Leitungsinduktivitäten.

Im länglichen Innenraum 25 der Innelektrode 17 ist ein Marx-Generator 26 untergebracht, der hochspannungsseitig an die Kapazität 15 des Resonators 11 angeschlossen ist, nämlich mit seinem Hochpotential an den Wellenstumpf 21 der Funkenstrecke 20 und mit seinem Niederpotential der Funkenstrecke 20 gegenüber, in Richtung, auf die Antenne 13 zu, axial distanziert an die gewöhnlich auf gemeinsames Masse- oder direkt auf Erdpotential 27 liegende Innenelektrode 17.

Für autarken Betrieb des Mikrowellengenerators 12 ist dieser im Hohlraum 28 seiner Antenne 13 mit einer Versorgung 29 für Gleichspannung ausgestattet. Die besteht in diesem Beispielsfalle aus einer (vorzugsweise wieder auflädbaren) Batterie 30 mit nachfolgendem, hier symmetrisch zum Erdpotential 27 arbeitendem Gleichspannungswandler 31 zum Speisen des Marx-Generators 26 über eine wie skizziert durch den Flaschen-Hals 18 der Innenelektrode 17 verlaufende Verkabelung.

Zum Initiieren des Mikrowellengenerators 12 ist dieser mit einem extern triggerbaren Marx-Generator 26 ausgestattet. Dafür verfügt jener über eine triggerbare Funkenstrecke 32 unter seinen Funkenstrecken zum Umschalten von der Parallel- auf die Serienschaltung seiner Kondensatoren. Zum Anregen ihres Durchzündens kann eine solche nicht selbstschaltende sondern triggerbare Funkenstrecke 32 konstruktiv mit einer zusätzlichen Elektrode zur Potentialzufuhr aus einer Zündschaltung 33 ausgelegt sein, oder sie reagiert auf andersartige externe Energiezufuhr, etwa mittels UV- oder Laser-Blitzlicht, aus der Zündschaltung 33. Diese wird gegen Umwelteinflüsse gut abgeschirmt innerhalb des Resonators 11, etwa wie skizziert im Marx-Generator 26 selbst, realisiert und aus Gründen des Störschutzes bevorzugt optoelektronisch getriggert. Dafür ist konzentrisch etwa in einem die Antenne 13 über ihrer größeren Grundfläche nach außen abschließenden Deckel oder, wie hier beispielshalber skizziert, im Boden 22 der Außenelektrode 16 ein Photosensor 34 für externe optische Anregung zugänglich. Vorzugsweise weist der davor gelegene Wellenstumpf 21 einen Längskanal 35 für die geschützte Verkabelung vom Photosensor 34 zur Zündschaltung 33 auf.

Wenn mehrere derartig ausgestatteter Basismodule 10 etwa in einem Montagerahmen zu einem Array gruppiert sind, genügt, erforderlichenfalls bei Angleichen der wirksamen Licht-Laufzeiten über passend abgeleängte Lichtwellenleiter, das Generieren eines externen Lichtblitzes, um alle Mikrowellengeneratoren 12 über ihre Photosensoren 34 gleichzeitig zu initiieren und so eine optimale Überlagerung der einzelnen Antennenabstrahlungen zu erzielen. Dagegen führt es in als solcher bekannter Weise zum gesteuerten Strahlschwenken, etwa bei stationär installiertem Array, wenn jedem Photosensor 34 des Array eine Lichtquelle 36, etwa eine Strahlung emittierende Halbleiterdiode örtlich zugeordnet wird und diese Lichtquellen von einer externen Steuerschaltung her in definierter Folge geringfügig gegeneinander zeitverzögert bestromt werden.

### Bezugszeichenliste

- 10: Basismodul
- 11: Lambda-Viertel-Resonator
- 12: Mikrowellen-Generator
- 13: Antenne
- 14: Gehäuse
- 15: Kapazität
- 16: topfförmige Außenelektrode
- 17: flaschenförmige Innenelektrode
- 18: Hals (von 17)
- 19: kleine Grundfläche (von 13)
- 20: Kurzschluss-Funkenstrecke (zwischen 16-17)
- 21: Wellenstumpf (auf 22)
- 22: Boden (von 16)
- 23: Loch (in 24)
- 24: Boden (von 17)
- 25: Innenraum (von 17)
- 26: Marx-Generator
- 27: Erdpotential
- 28: Hohlraum (in 13)
- 29: Gleichspannungs-Versorgung (mit 30, 31)
- 30: Batterie
- 31: Gleichspannungswandler
- 32: triggerbare Funkenstrecke (in 26)
- 33: Zündschaltung (für 32)
- 34: Photosensor (in 22, für 33)
- 35: Längskanal (durch 21, von 34 nach 33)
- 36: Lichtquelle

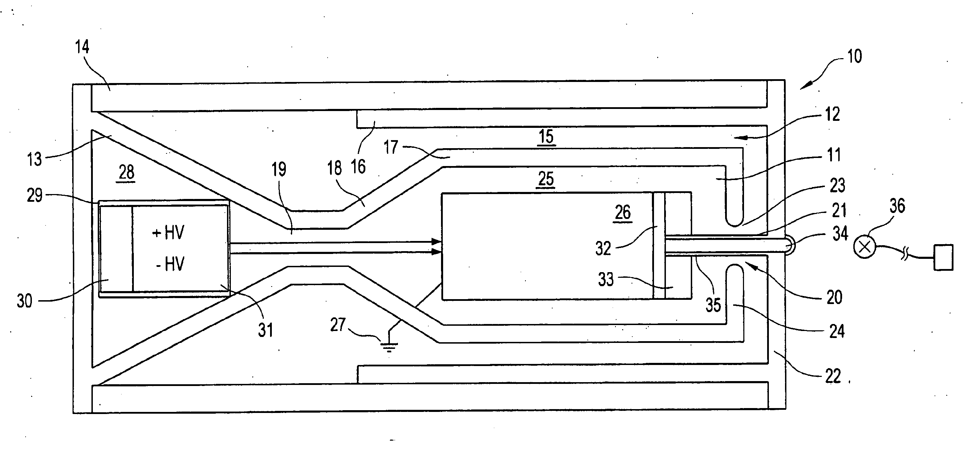

## Patentansprüche

1. Konzentrisch aufgebauter Hochleistungs-Mikrowellengenerator (12) mit aus einem Marx-Generator (26) aufladbarem und über eine Funkenstrecke (20) kurzschließbarem Resonator (11) mit hohlzylindrischen Elektroden (16, 17) für Abstrahlen kurzer Impulse über- eine Antenne (13), insbesondere zur Gruppierung in einem Array,
**dadurch gekennzeichnet,**
**dass** im Innenraum (25) der Innenelektrode (17) ein mit einer extern triggerbaren Funkenstrecke (32) ausgestatteter Marx-Generator (26) angeordnet ist.

2. Mikrowellen-Generator nach Anspruch 1,
**dadurch gekennzeichnet,**
**dass** die Kurzschluss-Funkenstrecke (20) ringförmig ausgelegt ist.

3. Mikrowellen-Generator nach dem vorangehenden Anspruch,
**dadurch gekennzeichnet,**
**dass** die Kurzschluss-Funkenstrecke (20) einen vom Boden (22) einer topfförmigen Außenelektrode (16) in ein Loch (23) im Boden (24) einer flaschenförmigen Innenelektrode (17) hinein ragenden Wellenstumpf (21) aufweist.

4. Mikrowellen-Generator nach dem vorangehenden Anspruch,
**dadurch gekennzeichnet,**
**dass** der Marx-Generator (26) ausgangsseitig einerseits an die Innenelektrode (17) und andererseits über den Wellenstumpf (31) an die Außenelektrode (16) angeschlossen ist.

5. Mikrowellen-Generator nach einem der vorangehenden Ansprüche,
**dadurch gekennzeichnet, dass** der Marx-Generator (26) eingangsseitig an eine Gleichspannungs-Versorgung (29) angeschlossen ist, die im Hohlraum (28) der trichterförmigen Antenne (13) untergebracht ist.

6. Mikrowellen-Generator nach dem vorangehenden Anspruch,
**dadurch gekennzeichnet,**
**dass** die Versorgung (29) einen Gleichspannungswandler (31) hinter einer Batterie (30) aufweist.

7. Mikrowellen-Generator nach einem der vorangehenden Ansprüche,
**dadurch gekennzeichnet,**
**dass** der Marx-Generator (26) mit einer extern anregbaren Zündschaltung (33) für seine triggerbare Funkenstrecke (32) ausgestattet ist.

8. Mikrowellen-Generator nach dem vorangehenden Anspruch,
**dadurch gekennzeichnet,**
**dass** eine über einen Photosensor (34) optisch anregbare Zündschaltung (33) vorgesehen ist.

9. Mikrowellen-Generator nach dem vorangehenden Anspruch,
**dadurch gekennzeichnet,**
**dass** der Photosensor (34) beim Boden (22) der Außenelektrode (16) hinter einem hohlen Wellenstumpf (21) angeordnet ist.

10. Verwendung von Mikrowellen-Generatoren (12) nach einem der vorangehenden Ansprüche zum Erstellen eines Generätor-Array.

11. Array aus Mikrowellen-Generatoren (12) gemäß Anspruch 10.

## Claims

1. Concentrically constructed high-power microwave generator (12) having a resonator (11) which can be charged from a Marx generator (26), can be shortcircuited via a spark gap (20) and has hollow-cylindrical electrodes (16, 17) for emitting short pulses via an antenna (13), in particular for grouping in an array,
**characterized**
**in that** a Marx generator (26) which is equipped with an externally triggerable spark gap (32) is arranged in the interior (25) of the inner electrode (17).

2. Microwave generator according to Claim 1,
**characterized**
**in that** the short-circuiting spark gap (20) is annular.

3. Microwave generator according to the preceding claim,
**characterized**
**in that** the short-circuiting spark gap (20) has a shaft stub (21) which projects from the base (22) of an outer electrode (16), which is in the form of a pot, into a hole (23) in the base (24) of an inner electrode (17), which is in the form of a bottle.

4. Microwave generator according to the preceding claim,
**characterized**
**in that** the output side of the Marx generator (26) is connected on the one hand to the inner electrode (17) and on the other hand via the shaft stub (31) to the outer electrode (16).

5. Microwave generator according to one of the preceding claims,
**characterized**
**in that** the input side of the Marx generator (26) is connected to a DC voltage supply (29), which is accommodated in the cavity (28) in the antenna (13), which is in the form of a funnel.

6. Microwave generator according to the preceding claim,
**characterized**
**in that** the supply (29) has a DC/DC voltage converter (31) behind a battery (30).

7. Microwave generator according to one of the preceding claims,
**characterized**
**in that** the Marx generator (26) is equipped with a triggering circuit (33) which can be energized externally, for its triggerable spark gap (32).

8. Microwave generator according to the preceding claim,
**characterized**
**in that** a triggering circuit (33) is provided which can be energized optically via a photosensor (34).

9. Microwave generator according to the preceding claim,
**characterized**
**in that** the photosensor (34) is arranged close to the base (22) of the outer electrode (16), behind a hollow shaft stub (21).

10. Use of microwave generators (12) according to one of the preceding claims for creation of a generator array.

11. Array comprising microwave generators (12) according to Claim 10.

## Revendications

1. Générateur de microondes de grande puissance (12) de construction concentrique, comprenant un résonateur (11) qui peut être chargé par un générateur de Marx (26) et qui peut être court-circuité par une distance de décharge (20) avec des électrodes (16, 17) cylindriques creuses pour émettre de courtes impulsions par le biais d'une antenne (13), notamment en vue d'un groupage en une matrice, **caractérisé en ce qu'**un générateur de Marx (26) équipé d'une distance de décharge (32) à déclenchement externe est disposé dans l'espace intérieur (25) de l'électrode intérieure (17).

2. Générateur de microondes selon la revendication 1, **caractérisé en ce que** la distance de décharge (20) à court-circuit est conçue en forme d'anneau.

3. Générateur de microondes selon la revendication précédente, **caractérisé en ce que** la distance de décharge (20) à court-circuit présente un bout d'arbre (21) qui fait saillie depuis le fond (22) d'une électrode extérieure (16) en forme de pot dans un trou (23) dans le fond (24) d'une électrode intérieure (17) en forme de bouteille.

4. Générateur de microondes selon la revendication précédente, **caractérisé en ce que** la sortie du générateur de Marx (26) est reliée d'une part à l'électrode intérieure (17) et d'autre part à l'électrode extérieure (16) par le biais du bout d'arbre (31).

5. Générateur de microondes selon l'une des revendications précédentes, **caractérisé en ce que** l'entrée du générateur de Marx (26) est reliée à une source de tension continue (29) qui est logée dans l'espace creux (28) de l'antenne en forme d'entonnoir (13).

6. Générateur de microondes selon la revendication précédente, **caractérisé en ce que** la source (29) présente un convertisseur de tension continue (31) derrière une batterie (30).

7. Générateur de microondes selon l'une des revendications précédentes, **caractérisé en ce que** le générateur de Marx (26) est équipé d'un circuit d'amorçage (33) à excitation externe pour sa distance de décharge (32) à déclenchement.

8. Générateur de microondes selon la revendication précédente, **caractérisé en ce qu'**il est prévu un circuit d'amorçage (33) qui peut être excité de manière optique par le biais d'un détecteur photoélectrique (34).

9. Générateur de microondes selon la revendication précédente, **caractérisé en ce que** le détecteur photoélectrique (34) est disposé au niveau du fond (22) de l'électrode extérieure (16) derrière un bout d'arbre creux (21).

10. Utilisation de générateurs à microondes (12) selon l'une des revendications précédentes pour édifier une matrice de générateurs.

11. Matrice de générateurs à microondes (12) selon la revendication 10.
